(19) Europäisches Patentamt / European Patent Office / Office européen des brevets

(11) EP 2 887 546 B1

(12) **EUROPEAN PATENT SPECIFICATION**

(45) Date of publication and mention
of the grant of the patent:
**07.11.2018 Bulletin 2018/45**

(21) Application number: **13199270.3**

(22) Date of filing: **23.12.2013**

(51) Int Cl.:
*H03K 17/082* *(2006.01)*    *H03K 17/18* *(2006.01)*

(54) **Monitoring method and device for power semiconductor switch**

Überwachungsverfahren und Vorrichtung für Leistungshalbleiterschalter

Procédé et dispositif de surveillance de commutateur à semi-conducteur de puissance

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**24.06.2015 Bulletin 2015/26**

(73) Proprietor: **ABB Schweiz AG
5400 Baden (CH)**

(72) Inventor: **Peltonen, Lauri
00380 Helsinki (FI)**

(74) Representative: **Kolster Oy Ab
(Salmisaarenaukio 1)
P.O. Box 204
00181 Helsinki (FI)**

(56) References cited:
**US-A1- 2007 070 567     US-A1- 2012 200 320
US-A1- 2013 229 208     US-A1- 2013 293 287
US-B2- 7 768 337**

EP 2 887 546 B1

**Description**

FIELD OF THE INVENTION

The present invention relates to monitoring operation of a power semiconductor switch, and particularly to monitoring supply voltages of a gate driver controlling the switch.

BACKGROUND INFORMATION

In an inverter or a frequency converter, power semiconductor switches are typically each controlled to one of two operational states: a conductive state (i.e. an on-state) or a non-conductive state (i.e. an off-state). In simplified terms, current flows through the switch in the conductive state and a voltage over the switch is near to zero. In the non-conducting state, the switch does not conduct current, and the voltage over the switch is at a higher level. For example, in the case of an inverter, the voltage over a switch in the non-conducting state may be the whole voltage (or half of the voltage) of the DC link of the inverter. Power semiconductor switches may be IGBTs or MOSFETs, for example.

Gate drivers may be used for turning the switches on or off. A gate driver may use a positive voltage for turning a power semiconductor switch on and a negative voltage for turning the switch off. By using a negative turn-off voltage, spurious turn-ons of the switch in the event of voltage spikes on the gate of the switch may be prevented. The supply voltages may be provided by an isolated power supply.

Detecting short circuit conditions may be important in some applications using power semiconductor switches. For example, fast and reliable short circuit detection may be desirable to avoid permanent damage to a switch and/or the related circuitry.

In order to detect a short circuit, a saturation voltage of a switch may be measured. The saturation voltage may be represented by a collector-emitter voltage of an IGBT, for example. It may be enough to know whether the voltage is above or below a certain limit. The saturation voltage may be compared with a positive voltage of the gate driver's supply, for example.

In order to avoid false short circuit faults during a switching event, the short circuit detection may include a small delay which prevents reading of the saturation input before IGBT has switched on completely.

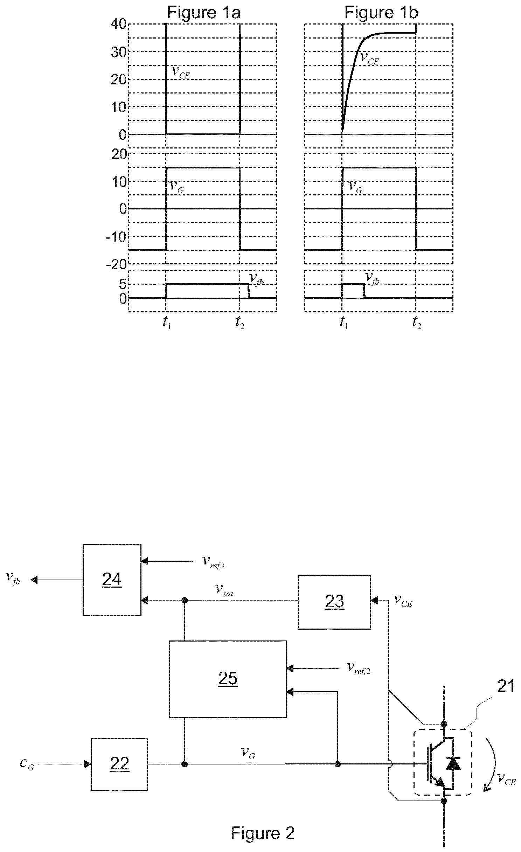

Figures 1a and 1b show exemplary waveforms of short circuit detection based on a measurement of a collector-emitter voltage $v_{CE}$. Figure 1a shows the waveforms during normal operation. A gate voltage $v_G$ is used to control a semiconductor switch. At instant $t_1$, the gate voltage switches from - 15 V to 15 V, and the switch turns on. The collector-emitter voltage $v_{CE}$, drops to a near-zero value. A two-level saturation feedback $v_{fb}$ signal is generated by comparing the collector-emitter voltage $v_{CE}$ to a set detection limit, in this case 15 V. The collector-emitter voltage $v_{CE}$ is lower that the limit, and thus the saturation feedback $v_{fb}$ is set to a high level which in this case is 5 V.

At instant $t_2$ in Figure 1a, the gate voltage switches back to -15 V. The switch turns off, and the collector-emitter voltage $v_{CE}$ rises above the set limit. After a small delay, the saturation feedback signal $vf_b$ is set to a low level which in this case is 0 V.

Figure 1b shows waveforms during a short circuit. Again, at instant $t_1$, the gate voltage switches from -15 V to 15 V, the switch turns on, and the collector-emitter voltage $v_{CE}$ drops to a near-zero value. The collector-emitter voltage $v_{CE}$ is lower that the detection limit and is set to the high level. However, instead of remaining near zero, the collector-emitter voltage $v_{CE}$ starts to rise again as a large short circuit current starts to flow through the switch. The collector-emitter voltage $v_{CE}$ exceeds the detection limit and, after a small delay, the saturation feedback signal $v_{fb}$ is set again to the low level.

At instant $t_2$ in Figure 1b, the gate voltage switches back to -15 V. The switch turns off, and the collector-emitter voltage $v_{CE}$ rises to the high, non-conductive state level.

The saturation feedback $v_{fb}$ in Figures 1a and 1b is used as a fault signal. By monitoring the saturation feedback $v_{fb}$, a failure of a component can be detected and the system may shut down in order to prevent damage or safety hazard. The switch may be slowly shut off in order to prevent damaging it, for example.

The saturation feedback signal may also be coupled with other failures. For example, a failure in the gate driver may also cause an indication of a fault. However, it may be impossible to distinguish one type of failure from another in this manner.

U.S. patent application US 2007/070567 A1 describes desaturation circuit for an IGBT. US patent US7768337 also discloses a desaturation circuit and a short circuit detection means for an IGBT.

BRIEF DISCLOSURE

An object of the present disclosure is to provide a method and a device for implementing the method so as to alleviate the above disadvantage. The objects of the invention are achieved by a method and a device characterized by what is stated in the independent claims. The preferred embodiments of the invention are disclosed in the dependent claims.

The disclosed method may be used for monitoring a semiconductor switch and a gate driver controlling the switch. The power semiconductor switch may be configured to be controlled to a conductive state or a non-conductive state responsive to a gate voltage signal generated by the gate driver unit. The disclosed method may comprise generating a saturation feedback signal on the basis of a saturation voltage signal. The saturation voltage signal may be responsive to a voltage over the switch so that short circuits during the conducting state of the power semiconductor switch may be detected.

In addition, the saturation voltage signal may also be controlled on the basis of the gate voltage signal. For example, during the non-conductive state, the saturation voltage signal may be responsive to the level of the gate voltage signal. In this manner, the saturation feedback (which is responsive to the saturation voltage) may be used to relay information on the states of the gate voltage signal and the gate driver generating the gate voltage signal. The saturation feedback signal can indicate if a supply voltage used for generating a voltage level driving a switch into the non-conducting state has a voltage level fulfilling the limits set to it.

By combining the non-conductive state information to the conductive state information, the disclosed method is able to give more meaningful fault information than just a short circuit fault. The disclosed method may indicate a broken component in the gate driving circuit. This additional information may be used to detect a failing component even before the power semiconductor switch shows abnormal behaviour. Thus, a warning can be given before a fault stopping a process occurs.

The disclosed method may be implemented with minimal additional components. As the additional monitoring does not require adding isolation channels but uses an existing saturation voltage signal, there is no significant price increase.

BRIEF DESCRIPTION OF THE DRAWINGS

In the following the invention will be described in greater detail by means of preferred embodiments with reference to the attached drawings, in which

Figures 1a and 1b show exemplary waveforms of short circuit detection based on a measurement of a collector-emitter voltage;
Figure 2 shows an exemplary monitoring device implementing the disclosed method;
Figures 3a to 3d show exemplary waveforms of the operation of the device as shown in Figure 2;
Figure 4 shows an exemplary, simplified embodiment of the disclosed device;
Figure 5 shows another exemplary, simplified embodiment of the monitoring device;
Figure 6 shows yet another exemplary embodiment of the monitoring device;
Figure 7 shows yet another exemplary embodiment of the disclosed monitoring device; and
Figures 8a to 8f show exemplary waveforms of the device of Figure 7.

DETAILED DISCLOSURE

This document discloses a method for a gate-controlled power semiconductor switch. The power semiconductor switch may be configured to be controlled to a conductive state or a non-conductive state responsive to a gate voltage signal generated by the gate driver unit.

The disclosed method may comprise generating a saturation voltage signal which is responsive to a voltage over the power semiconductor switch. The saturation voltage signal may be controlled also on the basis of the gate voltage signal. A saturation feedback signal may be determined on the basis of the saturation voltage signal.

The disclosed method may control the saturation voltage on the basis of the operational state of the power semiconductor switch. During the conductive state of the power semiconductor switch, the saturation voltage may be used for detecting short circuits. However, during the non-conductive state, the saturation voltage signal may be responsive to the level of the gate voltage signal. Thus, the saturation voltage signal may be used for diagnosing supply voltages of the gate driver. The resulting saturation signal waveform may then be analysed in order to detect different fault conditions, like a missing positive and/or negative supply voltage. A failing component may be detected even before the switching element shows incorrect behaviour. Thus, the disclosed method is able to produce further diagnostic information in addition to the short circuit information.

Figure 2 shows an exemplary monitoring device implementing the disclosed method. In Figure 2, a power semiconductor switch 21 in the form of an IGBT is controlled by a gate driver 22. Alternatively, the power semiconductor switch may be a MOSFET, for example. The gate driver 22 controls a gate voltage $v_G$ on the basis of a control signal $c_G$.

In Figure 2, the device comprises measuring means 23 for measuring a voltage $v_{CE}$ over a power semiconductor switch 21. The measuring means 23 generate a saturation voltage $v_{sat}$ on the basis of the voltage $v_{CE}$. Feedback means 24 determine a saturation feedback voltage $v_{fb}$ on the basis of a first voltage difference $v_{ref,1}$ - $v_{sat}$, i.e. a voltage difference between the first reference $v_{ref,1}$ and the saturation voltage $v_{sat}$ in Figure 2. For example, the first voltage difference may be compared with a first threshold, and the saturation feedback voltage $v_{fb}$ may be generated on the basis of the comparison.

In Figure 2, the saturation voltage signal $v_{sat}$ may be controlled on the basis of the gate voltage signal $v_G$ by using control means 25. During the non-conductive state of the power semiconductor switch 21, the control means 25 may connect an output of the gate driver unit 22 driving the gate voltage signal $v_G$ to a saturation voltage signal line carrying the saturation voltage signal $v_{sat}$ so that the saturation voltage signal $v_{sat}$ is responsive to the gate driver 22 output.

For example, the control means 25 may comprise an auxiliary switch connected between a saturation voltage signal line carrying the saturation voltage signal $v_{sat}$ and an output of the gate driver unit 22 driving the gate voltage signal $v_G$. The auxiliary switch may be configured to be controlled to a conductive state or a non-conductive state on the basis of the level of the gate voltage signal. The control means 25 may control the auxiliary switch on the basis of a second voltage difference $v_{ref,2}$ - $v_G$, i.e. a voltage difference between the gate voltage signal $v_G$ and the second reference $v_{ref,2}$. If the difference exceeds a second threshold, the auxiliary switch is driven into the conductive state.

Under normal operation, the gate driver 22 drives the gate voltage to a positive voltage during the conductive state of the power semiconductor switch 21. The difference between the second reference signal $v_{ref,2}$ and the gate voltage signal $v_G$ does not exceed the set threshold, and the control means 25 control the auxiliary switch to the non-conductive state. Thus, only the measuring means 23 drive the saturation voltage signal $v_{sat}$. The saturation voltage signal $v_{sat}$ is responsive to the voltage $v_{CE}$ over the power semiconductor switch 21.

During the non-conductive state of the power semiconductor switch 21, however, the gate voltage $v_G$ is negative, and the difference between the second reference signal $v_{ref,2}$ and the gate voltage signal $v_G$ exceeds the set limit. The control means 25 turn the auxiliary switch on, and the saturation voltage signal $v_{sat}$ becomes responsive to the gate voltage signal $v_G$.

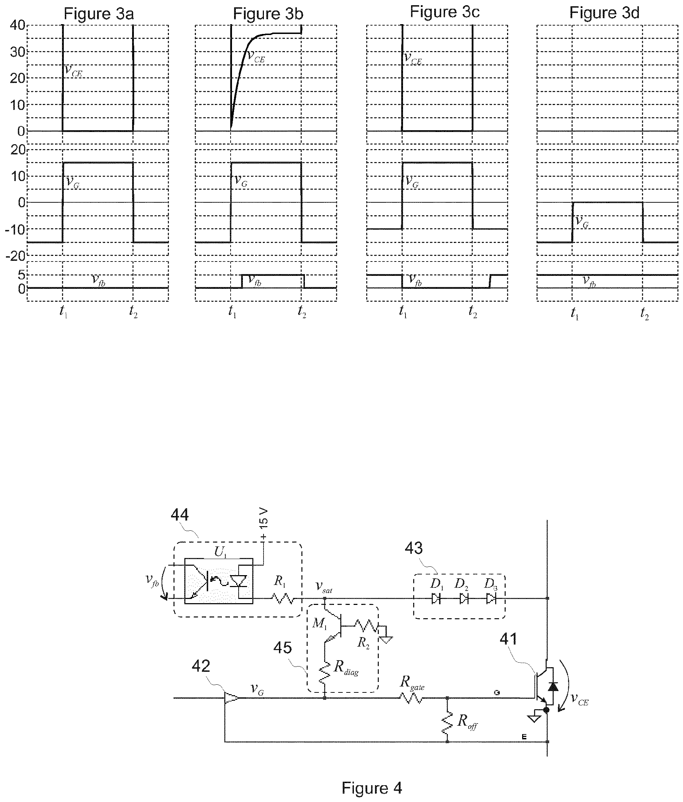

Figures 3a to 3d show exemplary waveforms of operation of the device in Figure 2. In Figures 3a to 3d, the IGBT 21 is configured to be controlled by a gate voltage $v_G$ that alternates between voltage levels -15V and 15 V. These voltage levels are represented with respect to a voltage potential of the emitter of the power semiconductor switch 21. The emitter voltage potential acting as a ground potential may be obtained from an auxiliary emitter of the IGBT 21, for example. The second reference voltage $v_{ref,2}$ is tied to the emitter voltage potential of the power semiconductor switch.

The saturation feedback signal $v_{fb}$ in Figure 3 is a two-level signal having a 5 V high level and a 0 V low level. The saturation feedback signal $v_{fb}$ is generated on the basis of the first voltage difference $v_{ref,1}$ - $v_{sat}$. A low saturation feedback signal $v_{fb}$ is generated if the first voltage difference exceeds the first threshold. If not, a high saturation feedback signal $v_{fb}$ is generated instead. The first reference $v_{ref,1}$ is 15 V in Figures 3a to 3d.

Figure 3a shows the waveforms during normal operation. The gate voltage signal $v_G$ at a normal non-conducting state level is at -15 V. The second voltage difference $v_{ref,2}$ - $v_G$ is higher than the second threshold, so the auxiliary switch is set to a conducting state and the gate driver 22 pulls the saturation voltage $v_{sat}$ down. As a result, the first voltage difference exceeds the first threshold and, thus, the saturation feedback is initially low.

At instant $t_1$, the gate voltage $v_G$ switches from -15 V to 15 V, and the power semiconductor switch 21 turns on. The second voltage difference $v_{ref,2}$ - $v_G$ is no longer higher than the second threshold, and thus, the gate driver 22 does not drive the saturation voltage $v_{sat}$. Instead, the saturation voltage $v_{sat}$ is driven by the measuring means 23. The saturation voltage $v_{sat}$, which in this case is the collector-emitter voltage, drops to a near-zero value. The first voltage difference $v_{ref,1}$ - $v_{sat}$ exceeds the first threshold, and thus, the saturation feedback $v_{fb}$ remains low.

At instant $t_2$ in Figure 3a, the power semiconductor switch 21 turns off as the gate voltage switches back to -15 V. The difference $v_{ref,2}$ - $v_G$ rises above the second threshold, and the control means 25 turn the auxiliary switch on. Thus, the gate driver 22 pulls the saturation voltage $v_{sat}$ down, and the saturation feedback signal $v_{fb}$ remains low.

Figure 3b shows waveforms during a short circuit. Initially, the second voltage difference $v_{ref,2}$ - $v_G$ exceeds the second threshold, and the gate driver 22 drives the saturation voltage $v_{sat}$. Thus, the saturation feedback is initially low.

At instant $t_1$, the gate voltage rises from -15 V to 15 V, and the power semiconductor switch 21 turns on. The saturation voltage $v_{sat}$ is driven by the measuring means 23 and drops to a near-zero value. The first voltage difference $v_{ref,1}$ - $v_{sat}$ is higher than the first threshold, and the saturation feedback $v_{fb}$ remains low. However, because of the short circuit current, the saturation voltage $v_{sat}$ starts to rise again. The second voltage difference $v_{ref,1}$ - $v_{sat}$ decreases until it is below the first threshold, and after a small delay, the saturation feedback $v_{fb}$ signal is set to the high level.

At instant $t_2$ in Figure 3b, the gate voltage switches back to -15 V. The power semiconductor switch 21 turns off, and the gate driver 22 drives the saturation voltage $v_{sat}$. The first voltage difference $v_{ref,1}$ - $v_{sat}$ again exceeds the first threshold, and the saturation feedback signal $v_{fb}$ changes to the low level.

Figure 3c shows waveforms during an abnormal negative supply voltage. In Figure 3c, the negative level of the gate voltage $v_G$ is -10 V. The second voltage difference $v_{ref,2}$ - $v_G$ is not higher than the second threshold, and thus, the gate driver 22 does not drive the saturation voltage $v_{sat}$. The measuring means 23 drive the saturation voltage $v_{sat}$

to the level of the voltage over the power semiconductor switch 21. Therefore, the voltage difference $v_{ref,1} - v_{sat}$ does not exceed the first threshold, and the saturation feedback is initially high. Alternatively, the device may be configured such that a -10 V second voltage difference $v_{ref,2} - v_G$ exceeds the second threshold and the gate driver 22 drives the saturation voltage $v_{sat}$. However, the low negative of the gate voltage $v_G$ generates a saturation voltage $v_{sat}$ that is too low for a voltage difference $v_{ref,1} - v_{sat}$ that would exceed the first threshold. As a result, the voltage difference $v_{ref,1} - v_{sat}$ does not exceed the first threshold, and the saturation feedback is initially high.

At instant $t_1$, the gate voltage $v_G$ switches from -10 V to 15 V, and the power semiconductor switch 21 turns on. The second voltage difference $v_{ref,2} - v_G$ is not higher than the second threshold, and thus, the gate driver 22 does not drive the saturation voltage $v_{sat}$. The saturation voltage $v_{sat}$ is driven by the measuring means 23. As there is no short circuit, the saturation voltage $v_{sat}$ drops to a near-zero value. The voltage difference $v_{ref,1} - v_{sat}$ is higher than the first threshold, and thus, the saturation feedback $v_{fb}$ is set to the low level.

At instant $t_2$ in Figure 3c, the gate voltage switches back to -10 V. The power semiconductor switch 21 turns off. The second voltage difference $v_{ref,2} - v_G$ is not sufficiently high to set the auxiliary switch to a conductive state. Thus, the gate driver 22 does not drive the saturation voltage $v_{sat}$. The measuring means 23 drive the saturation voltage $v_{sat}$ to the level of the voltage over the power semiconductor switch 21, and thus, the saturation feedback $v_{fb}$ is again set to the high level.

Figure 3d shows waveforms during a detection of an abnormal positive supply voltage level. Because of the abnormal positive supply voltage, the level of the gate voltage $v_G$ driving the power semiconductor switch 21 to a conductive state is 0 V. The negative supply voltage is normal, and the second voltage difference $v_{ref,2} - v_G$ is higher than the second threshold. Thus, the gate driver 22 drives the saturation voltage $v_{sat}$. However, since the first reference $v_{ref,1}$ is at an abnormally low level, the first voltage difference $v_{ref,1} - v_{sat}$ does not exceed the first threshold. Thus, the saturation feedback is initially at the high level.

At instant $t_1$, the gate voltage $v_G$ switches from -15 V to 0 V, which is not enough to turn the power semiconductor switch 21 on. The second voltage difference $v_{ref,2} - v_G$ is not higher than the second threshold, and thus, the gate driver 22 does not drive the saturation voltage $v_{sat}$. Instead, the saturation voltage $v_{sat}$ is driven by the measuring means 23. As the power semiconductor switch 21 is not turned on, the saturation voltage $v_{sat}$ does not drop. Thus, the first voltage difference $v_{ref,1} - v_{sat}$ is lower that the first threshold, and the saturation feedback $v_{fb}$ remains at the high level.

At instant $t_2$ in Figure 3d, the gate voltage switches back to -15 V. The power semiconductor switch 21 turns off. The second voltage difference $v_{ref,2} - v_G$ sets the auxiliary switch 25 to the conductive state. The gate driver 22 pulls the saturation voltage $v_{sat}$ down. However, because of the abnormally low level of the first reference $v_{ref,1}$, the first voltage difference $v_{ref,1} - v_{sat}$ does not exceed the first threshold. Thus, the saturation feedback remains at the high level.

Each of Figures 3a to 3d shows a different saturation feedback signal waveform. The waveforms may be used for distinguishing different fault conditions from each other. For example, in Figures 3c and 3d, a high saturation feedback signal during the non-conductive state of the power semiconductor switch may be used for indicating a faulty voltage supply in the gate driver.

This document further discloses a device for a power semiconductor switch configured to be controlled to a conductive state or a non-conductive state on the basis of a gate voltage signal. The gate voltage signal may be generated by a gate driver unit.

The device may comprise measuring means for generating a saturation voltage signal on the basis of a voltage over the power semiconductor switch, and feedback means for generating a saturation feedback signal on the basis of the saturation voltage signal. The saturation feedback signal may be determined on the basis of a first voltage difference, i.e. a voltage difference between a first reference voltage and the saturation voltage signal. The first voltage difference may be compared with a first threshold, and the saturation feedback signal may be generated on the basis of the comparison, for example.

The device may also comprise an auxiliary switch connected between a saturation voltage signal line carrying the saturation voltage signal and an output of the gate driver unit driving the gate voltage signal, wherein the auxiliary switch may be configured to be controlled to a conductive state or a non-conductive state on the basis of the gate voltage signal. For example, the device may comprise means for generating a voltage between the gate and source (or base and emitter) of the auxiliary switch on the basis of the gate voltage signal.

The auxiliary switch may be configured to be controlled on the basis of a second voltage difference, i.e. a voltage difference between a second reference signal and the gate voltage signal. The second voltage difference may be compared with a second threshold. The second reference voltage may be the emitter voltage potential measured from an auxiliary emitter of the power semiconductor switch, for example. Thus, the second threshold may be the threshold voltage of the auxiliary switch. If the power semiconductor switch is a MOSFET, the second reference voltage may be the source voltage potential, for example.

Figure 4 shows an exemplary, simplified embodiment of the disclosed monitoring device. In Figure 4, the power semiconductor switch is an IGBT 41. The IGBT 41 is controlled by a gate driver 42 through a gate resistor $R_{gate}$. A pull-down resistor $R_{off}$ is connected between the gate and the emitter of the power semiconductor switch 41.

In Figure 4, the saturation feedback $v_{fb}$ is generated on the basis of a saturation voltage signal $v_{sat}$ by a saturation feedback circuitry that comprises measuring means 43 and feedback means 44.

The measuring means 43 are formed by at least one diode connected to a collector (or drain) terminal of the power semiconductor switch for generating the saturation voltage signal $v_{sat}$. In Figure 4, three diodes $D_1$ to $D_3$ are used. The diodes may be high voltage PN diodes.

The diodes $D_1$ to $D_3$ allow a saturation voltage line carrying the saturation voltage $v_{sat}$ to be driven to the collector potential of the power semiconductor switch when the collector potential is below the saturation voltage $v_{sat}$, but they block a flow of current from said collector or drain terminal to the saturation voltage signal $v_{sat}$. Thus, the monitoring device is protected against a high collector-emitter voltage of the power semiconductor switch 41 during the non-conductive state.

The feedback means may comprise an isolator for providing a galvanic isolation between the saturation feedback signal and the saturation voltage signal. The isolator may be configured to produce the saturation feedback signal on the basis of the difference between the saturation voltage signal and the first reference voltage signal.

For example, in Figure 4 the feedback means 44 comprise a resistor $R_1$ and an isolator $U_1$ in the form of an optocoupler. A resistance between two output terminals of the isolator $U_1$ is responsive to a current between two input terminals. The inputs may be galvanically isolated from the outputs. The saturation feedback signal is read between the two output terminals of the isolator.

In Figure 4, one of the input terminals is connected to the saturation voltage signal through the resistor $R_1$. The other input terminal is connected to a first reference voltage signal $v_{ref,1}$ which in Figure 4 is a 15 V positive supply voltage supplying the gate driver unit 42. The emitter potential (or the source potential, if a power MOSFET is being used) of the power semiconductor switch acts as a ground potential for the positive supply voltage.

The current between the input terminals of the isolator $U_1$ is responsive to a first voltage difference over the series connection of the isolator $U_1$ and the resistor $R_1$. The first voltage difference also represents the voltage difference $v_{ref,1} - v_{sat}$ between the first reference $v_{ref,1}$ and the saturation voltage $v_{sat}$. When the first voltage difference $v_{ref,1} - v_{sat}$ rises above a first threshold, the current through the inputs of the isolator $U_1$ rises above a threshold, and the resistance between the outputs drops significantly. The saturation feedback signal $v_{fb}$ may be generated by connecting the output in series with a pull-up resistor, for example. This generates an active-low indicator signal, i.e. the output voltage is pulled down when the voltage difference between the input terminals exceeds the set limit.

In Figure 4, the auxiliary switch $M_1$ is a NPN-type BJT. The saturation voltage signal line is connected to a collector terminal of the auxiliary switch $M_1$. The output $v_G$ of the gate driver 42 unit is connected to an emitter terminal of the auxiliary switch $M_1$ through a resistor $R_{diag}$. A base terminal of the auxiliary switch $M_1$ is connected to a second reference voltage line through a resistor $R_2$. The second reference voltage line carries the second reference voltage $v_{ref,2}$ and is connected to an auxiliary emitter of the IGBT 41. The operational state of the auxiliary switch $M_1$ may be controlled on the basis of a second voltage difference $v_{ref,2} - v_G$ between the second reference voltage $v_{ref,2}$ and the gate driver output $v_G$. When the second voltage difference $v_{ref,2} - v_G$ rises, the base-emitter voltage of the auxiliary switch $M_1$ exceeds its threshold, and the auxiliary switch starts to conduct.

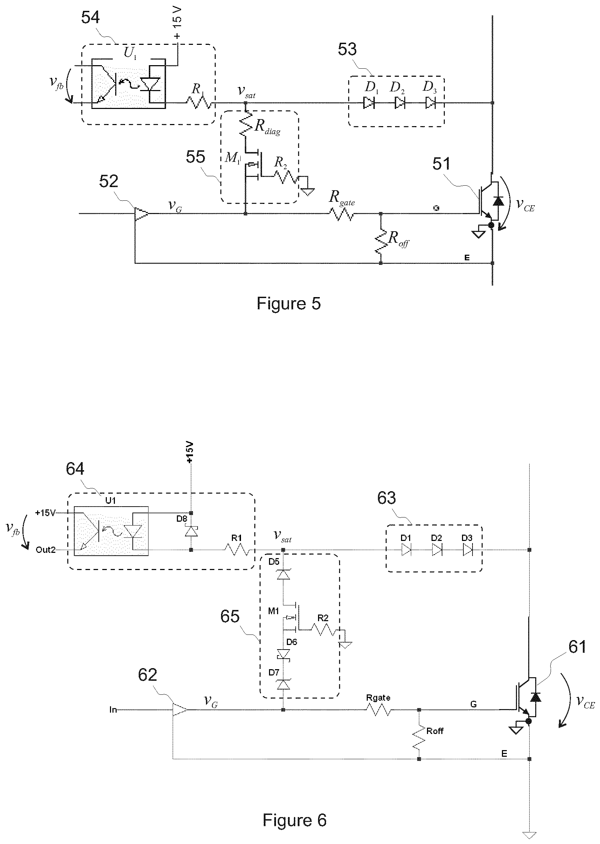

Figure 5 shows another exemplary, simplified embodiment of the monitoring device. The embodiment of Figure 5 is mostly the same as the embodiment of Figure 4. An IGBT 51 is controlled by a gate driver 52. Three high voltage PN diodes $D_1$ to $D_3$ form measuring means 53. The diodes $D_1$ to $D_3$ generate the saturation voltage signal. Feedback means 54 comprise an optocoupler $U_1$ and a resistor $R_1$.

In Figure 5, the auxiliary switch $M_1$ is a logic-level N-channel MOSFET. The saturation voltage signal line is connected to a drain terminal of the auxiliary switch $M_1$ through a resistor $R_{diag}$. The output of the gate driver unit 52 is connected to a source terminal of the auxiliary switch, and the second reference voltage line is connected to a gate terminal of the auxiliary switch through a resistor $R_2$.

Figure 6 shows yet another exemplary embodiment of the monitoring device. The embodiment of Figure 6 is mostly the same as the embodiment of Figure 5. An IGBT 61 is controlled by a gate driver 62. Three high voltage PN diodes $D_1$ to $D_3$ form measuring means 63. The diodes $D_1$ to $D_3$ generate the saturation voltage signal. Feedback means 64 comprise an optocoupler $U_1$, a resistor $R_1$, and a Schottky diode $D_8$ connected between the inputs of the optocoupler $U_1$. The first reference voltage signal for the feedback means 64 is the positive supply voltage supplying the gate driver unit with 15 V.

In Figure 6, the saturation voltage signal line is connected to a drain terminal of the auxiliary switch $M_1$ through a zener diode $D_5$. The zener diode $D_5$ is connected such that it blocks a flow of current from the saturation voltage signal line to the drain terminal until its zener voltage $V_{D5,z}$ is exceeded. The output of the gate driver unit 62 is connected to a source terminal of the auxiliary switch $M_1$ through a series-connection of a Schottky diode $D_6$ and a zener diode $D_7$. The Schottky diode $D_6$ is connected such that it blocks a flow of current from the gate driver output to the source terminal. The zener diode $D_7$ is connected such that it blocks a flow of current from the source terminal to gate driver output until its zener voltage $V_{D7,z}$ is exceeded. A second reference voltage line is connected to the emitter potential of the power semiconductor switch. The second reference voltage line is connected to a gate terminal of the auxiliary switch through

a resistor $R_2$.

In the following, the operation of the embodiment of Figure 6 is explained by using exemplary component values.

A resistance of the resistor $R_1$ may be approximately 400 Ω, for example; a forward voltage $V_{U1,f}$ for the optocoupler $U_1$ while in an on-state may be approximately 1.5 V; a threshold current $I_{U1,th}$ for the optocoupler may be approximately 1.5 mA; Thus, a first threshold $V_{th,1}$ for a first voltage difference $v_{ref,1}$ - $v_{sat}$ i.e. for a voltage difference between the first reference $v_{ref,1}$ and the saturation voltage $v_{sat}$ may be calculated as follows

$$V_{th,1} = (R_1 \cdot I_{U1,th}) + V_{U1,f} \approx 2 \text{ V}. \tag{1}$$

The zener voltage $V_{D7,z}$ of the zener diode $D_7$ may be 10 V, for example; a forward voltage $V_{D6,f}$ of the Schottky diode $D_6$ may be 0.3V; and a threshold voltage $V_{M1,th}$ for the voltage between the gate and source of the auxiliary switch $M_1$ may be approximately 2 V. Above the threshold voltage $V_{M1,th}$, the auxiliary switch $M_1$ is in conductive state. Thus, a second threshold $V_{th,2}$ for the second voltage difference, i.e. for the voltage difference between a second reference signal $v_{ref,2}$ and the gate voltage signal $v_G$ becomes

$$V_{th,2} = V_{M1,th} + V_{D6,f} + V_{D7,z} \approx 12 \text{ V}. \tag{3}$$

The voltage level of the second reference signal $v_{ref,2}$ may be set by adjusting the zener voltage $V_{D7,z}$.

During the non-conductive state under normal operation, the gate driver 62 outputs an off-state gate voltage $v_{G,off}$ in order to drive the power semiconductor switch 61 to a non-conducting state. The collector-emitter voltage of the power semiconductor switch is at a high level. In Figure 6, the off-state gate voltage $v_{G,off}$ may be -15 V. Thus, the second voltage difference $v_{ref,2}$ - $v_{G,off}$ (= 0 V -(-15 V)= 15 V) exceeds the second threshold $V_{th,2}$. The voltage between the gate and the source of the auxiliary switch $M_1$ is approximately 5 V, which is enough to turn the auxiliary switch $M_1$ on. A zener voltage $V_{D5,z}$ of the zener diode $D_5$ may be 14 V. The gate driver 62 drives the saturation voltage $v_{sat}$, for which the following value can be calculated

$$v_{sat} = v_{G,off} + V_{D7,z} + V_{D6,f} + V_{D5,z} = 9 \text{ V}. \tag{4}$$

The first voltage difference $v_{ref,1}$ - $v_{sat}$ (=15 V - 9 V = 6 V) is greater than the first threshold voltage $V_{th,1}$, and thus, the feedback signal is driven low.

When the power semiconductor switch 61 turns on during normal operation, the second voltage difference, now represented by a voltage difference between the second reference $v_{ref,2}$ and a conducting state gate voltage $v_{G,on}$, no longer exceeds the second threshold $V_{th,2}$:

$$v_{ref,2} - v_{G,on} \left( = 0 \text{ V} - 15 \text{ V} \right) < V_{th,2}. \tag{5}$$

As a result, the gate-source voltage of the auxiliary switch $M_1$ falls under its threshold voltage $V_{M1,th}$, and the auxiliary switch $M_1$ is turned off. Therefore, the saturation voltage $v_{sat}$ is driven by the diodes $D_1$ to $D_3$. Under normal operation, the voltage over the power semiconductor switch is so low that the resulting voltage difference $v_{ref,1}$ - $v_{sat}$ exceeds the first reference $v_{ref,1}$. The current through the inputs of the optocoupler $U_1$ is higher than the threshold current $I_{U1,th}$, and the optocoupler $U_1$ output is set low.

However, if a short circuit occurs, the collector-emitter voltage of the power semiconductor switch 61 rises, and the diodes $D_1$ to $D_3$ are not able to pull the saturation voltage $v_{sat}$ down. As a result, the resulting voltage difference $v_{ref,1}$ - $v_{sat}$ does not exceed the first threshold voltage $V_{th,1}$, and a short circuit is indicated by a high signal.

In addition to detecting short circuits, the embodiment of Figure 6 is able to detect an abnormal gate voltage levels during the non-conductive state of the power semiconductor switch 61. For example, if the off-state gate voltage $v_{G,off}$ is abnormally low, i.e. the second voltage difference $v_{ref,2}$ - $v_{G,off}$ is below the second threshold $V_{th,2}$, the gate-source voltage of the auxiliary switch $M_1$ falls under its threshold voltage $V_{M1,th}$, and the auxiliary switch $M_1$ is turned off. In Figure 6, the second threshold $V_{th,2}$ is 12 V, so off-state voltage levels of the gate voltage $v_{G,off}$ which are less negative than -12 V will cause the auxiliary switch $M_1$ to turn off. The collector-emitter voltage of the power semiconductor switch 61 is at a high, non-conductive state level, and the diodes $D_1$ to $D_3$ are not able to pull the saturation voltage $v_{sat}$ to a low voltage level. The resulting voltage difference $v_{ref,1}$ - $v_{sat}$ does not exceed the first reference $v_{ref,1}$, and an abnormal gate voltage is indicated by a high feedback signal.

Since the positive supply voltage of 15V serves as the first reference $v_{ref,1}$, the embodiment of Figure 6 is also able to detect abnormalities in the positive supply voltage during the non-conductive state of the power semiconductor switch 61.

During the non-conducting state, the saturation voltage $v_{sat}$ may be 9 V (see Equation 4). In order for the first voltage difference $v_{ref,1}$ - $v_{sat}$ to exceed the first threshold voltage $V_{th,1}$ (= 2V, Equation 1), the first voltage reference $v_{ref,1}$, in this case the positive supply voltage, has to be 11 V or more. If the positive supply voltage is less than 11 V, the first voltage difference $v_{ref,1}$ - $v_{sat}$ is less than the first threshold voltage $V_{th,1}$, the current through the optocoupler is lower than the threshold current $I_{U1,th}$ and the optocoupler $U_1$ output is set to the high level. The threshold level for triggering a low positive supply voltage may be controlled by adjusting the zener voltage $V_{D5,z}$ of the zener diode $D_5$. Similar voltage drop of the negative supply voltage may give similar results.

The above exemplary component values show one implementation of the embodiment of Figure 6. However, the embodiment is not limited to the values given in this document, but other values may also be used.

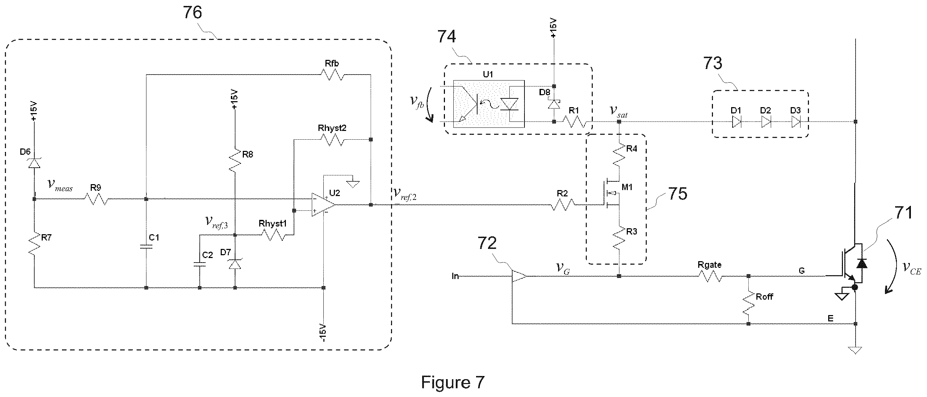

Figure 7 shows yet another exemplary embodiment of the disclosed monitoring device. The embodiment of Figure 7 shows similar features as the previous embodiments. An IGBT 71 is controlled by a gate driver 72. Three high voltage PN diodes $D_1$ to $D_3$ form measuring means 73 and generate the saturation voltage signal. Feedback means 74 comprise an optocoupler $U_1$, a resistor $R_1$, and a Schottky diode $D_8$. The first reference voltage signal $v_{ref,1}$ for the feedback means 74 is a positive supply voltage supplying the gate driver unit with 15 V. A negative supply voltage for the gate driver unit is -15 V. The emitter potential of the IGBT 71 serves as the ground potential for the supply voltages. A series connection of a resistor $R_4$, an auxiliary switch $M_1$, and a resistor $R_3$ form control means 75. The auxiliary switch $M_1$ is controlled on the basis of a difference between a second reference signal $v_{ref,2}$ and the gate voltage signal $v_G$. The output of the gate driver unit 72 is connected to a source terminal of the auxiliary switch $M_1$ through the resistor $R_3$. The saturation voltage signal line is connected to a drain terminal of the auxiliary switch $M_1$ through the resistor $R_4$.

In Figure 7, the second reference signal $v_{ref,2}$ is generated by reference voltage generating means 76 which are connected to a gate terminal of the auxiliary switch $M_1$ through a resistor $R_2$.

The reference voltage generating means 76 may be configured to modulate the second reference signal $v_{ref,2}$ in order to modulate the feedback signal $v_{fb}$ during the non-conductive state of the power semiconductor switch 71 such that the modulation of the feedback signal $v_{fb}$ is responsive to the levels of the positive supply voltage and/or the negative supply voltage. For example, the switching frequency and/or duty cycle of the modulation of the feedback signal $v_{fb}$ may be configured to be responsive to one or both of the supply voltages.

In Figure 7, the reference voltage generating means 76 generate a pulse-width-modulated second reference signal $v_{ref,2}$ that, in turn, produces a pulse-width-modulated feedback signal $v_{fb}$ during the non-conductive state of the IGBT 71. The switching frequency and duty cycle of the feedback signal $v_{fb}$ are responsive to the levels of the positive supply voltage and the negative supply voltage. The reference voltage generating means 76 comprise a comparator, a voltage reference, a voltage level shifter, and an RC circuit.

A resistor $R_8$, a zener diode $D_7$, and a capacitor $C_2$ are used to generate a third reference voltage $v_{ref,3}$.

The RC circuit is formed by resistors $R_9$ and $R_{fb}$, and a capacitor $C_1$. The comparator is formed by a comparator circuit $U_2$ with resistors $R_{hyst,1}$ and $R_{hyst,2}$ generating hysteresis. The comparator compares the voltage over the capacitor $C_1$ of the RC circuit with the voltage reference. The comparator output is fed back to the RC circuit through the resistor $R_{fb}$. As a result, a PWM signal is generated. The comparator output is used as the second reference signal $v_{ref,2}$.

The voltage level shifter in Figure 7 is formed by a zener diode $D_6$ and a resistor $R_7$. The level shifter measures the voltage difference between the positive supply voltage and the negative supply voltage. The level shifter then reduces a fixed voltage magnitude from the difference by using the zener diode $D_6$. A resulting voltage difference $v_{meas}$ may be measured over the resistor $R_7$.

The voltage difference $v_{meas}$ is fed to the RC circuit through the resistor $R_9$. Thus, the voltage over the capacitor is responsive to the voltage difference $v_{meas}$. A change in a level or levels of the gate driver supplies causes a change in the output frequency and the duty cycle of the generated PWM signal. With a low voltage difference $v_{meas}$, the duty cycle and the modulation frequency are small, and vice versa.

In the following, the operation of the embodiment of Figure 7 is explained by using exemplary component values.

The resistance of the resistor $R_8$ may be 11 kΩ; a zener voltage of the zener diode $D_7$ may be 9 V; and a capacitance of the capacitor $C_2$ may be 1 μF.

The comparator circuit $U_2$ may be supplied by 0 V (i.e. power semiconductor switch emitter potential) and -15 V. Thus, the output of the comparator circuit may alternate between 0 V and -15 V.

The resistors $R_{hyst,1}$ and $R_{hyst,2}$ may have values 1 kΩ and 510 kΩ, respectively; a capacitance of the capacitor $C_1$ may be 100 nF; and a resistance of the resistor $R_{fb}$ may be 7 kΩ. The combination of an RC time constant and the hysteresis of the comparator gives a base modulation frequency of approximately 90 kHz.

A voltage difference between the positive supply voltage (15 V) and the negative supply voltage (-15 V) may be in the neighborhood of a level of 30 V under normal operating conditions, for example. If the level of one or both supply voltages is too high (for example, the positive supply > 15 V or the negative supply < -15 V), the difference is above 30 V. If the level of one or both supply voltages is too low (for example, the positive supply < 15 V or the negative supply > -15 V), the difference is below 30 V.

For example, in Figure 7 the zener diode $D_6$ has a zener voltage of 20 V. Thus, the resulting voltage difference $v_{meas}$ is in the neighborhood of 10 V.

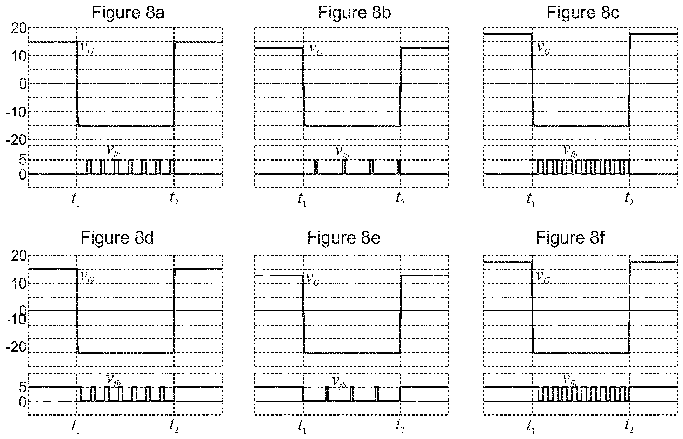

Figures 8a to 8f show exemplary waveforms of the device of Figure 7. In Figures 8a to 8f, period $t_1$ to $t_2$ shows a non-conducting state of the power semiconductor switch.

Figures 8a to 8c show waveforms where the IGBT 71 switches correctly and no short circuit is detected.

Figure 8a shows operation when the supply voltages for the gate driver are within set operating ranges. During the conductive state of the IGBT 71, the feedback signal acts as a short circuit detector. No short circuit is detected and thus, the feedback signal is low. During the non-conductive state of the IGBT 71, the feedback signal is modulated. The switching frequency and duty cycle of the modulation are responsive to the levels of the positive supply voltage and the negative supply voltage.

Figure 8b shows waveforms of operation when the positive supply voltage is too small. The switching frequency and the duty cycle of the pulse-shaped feedback signal are now smaller. A too small negative supply voltage induces a corresponding waveform.

Figure 8c shows waveforms of operation when the positive supply voltage is too high. The switching frequency and the duty cycle of the pulse-shaped feedback signal are now higher. A too large negative supply voltage (i.e. more negative voltage) induces a corresponding waveform.

Figures 8d to 8f show waveforms where the collector of the IGBT 71 is disconnected and no current flows through it. The collector-emitter voltage remains at a high level throughout the switching cycle.

Figure 8d shows operation when the supply voltages for the gate driver are within set operating ranges. During the conductive state of the IGBT 71, the feedback signal acts as a short circuit detector. However, since the collector is disconnected and no current flows through the IGBT 71, the collector-emitter voltage of the IGBT 71 remains at a high level. Thus, the feedback signal is high. During the non-conductive state of the IGBT 71, the feedback signal is modulated.

Figure 8e shows waveforms of operation when the positive supply voltage is too small. The switching frequency and the duty cycle of the pulse-shaped feedback signal are now smaller. A too small negative supply voltage induces a corresponding waveform. During the conductive state of the IGBT 71, the feedback signal is high.

Figure 8f shows waveforms of operation when the positive supply voltage is too high. The switching frequency and the duty cycle of the pulse-shaped feedback signal are now higher. A too large negative supply voltage (i.e. more negative voltage) induces a corresponding waveform. During the conductive state of the IGBT 71, the feedback signal is high.

With this information, a voltage feedback can be generated. On the basis of the voltage feedback, the supply voltages may be adjusted in order to achieve correct gate driver output voltage levels. Also, voltage droops during high frequency switching of the power semiconductor switch may be measured, or a faulty gate driver power supply may be detected.

It will be obvious to a person skilled in the art that the inventive concept can be implemented in various ways. The invention and its embodiments are not limited to the examples described above but may vary within the scope of the claims.

**Claims**

1. A monitoring device for a power semiconductor switch (21) configured to be controlled to a conductive state or a non-conductive state on the basis of a gate voltage signal driven by a gate driver unit (22), wherein the device comprises

   measuring means (23) for generating a saturation voltage signal on the basis of a voltage over the power semiconductor switch (21),

   an auxiliary switch connected between a saturation voltage signal line carrying the saturation voltage signal and an output of the gate driver unit (22) driving the gate voltage signal, wherein the auxiliary switch is configured to be controlled to a conductive state or a non-conductive state on the basis of a difference between a second reference signal and the gate voltage signal so that the saturation voltage signal becomes responsive to the level of the gate voltage signal during the non-conductive state of the power semiconductor switch (21) in order to use the saturation voltage signal for diagnosing a supply voltage of the gate driver (22), and

   feedback means (24) for generating a saturation feedback signal on the basis of the saturation voltage signal, wherein

   the second reference signal is a second reference voltage that is the emitter or source voltage potential of the power semiconductor switch (21),

   or wherein the device comprises reference voltage generating means (76) for generating the second reference signal, wherein the reference voltage generating means (76) are configured to modulate the second reference signal in order to modulate the feedback signal during the non-conductive state of the power semiconductor switch (21), wherein the frequency and/or duty cycle of the modulation of the feedback signal is responsive to a level of a positive supply voltage and/or a negative supply voltage supplying the gate driver unit (22).

2. A monitoring device as claimed in claim 1, wherein the device is configured to control the saturation voltage signal on the basis of the operational state of the power semiconductor switch (21).

3. A monitoring device as claimed in claim 1 or 2, wherein the saturation feedback signal is determined on the basis of a difference between a first reference voltage and the saturation voltage signal.

4. A monitoring device as claimed in claim 1, wherein
the second reference voltage is the emitter or source voltage potential of the power semiconductor switch (21),
the second reference voltage is measured from an auxiliary emitter of the power semiconductor switch (21).

5. A monitoring device as claimed in claim 1 or 4, wherein
the second reference voltage is the emitter or source voltage potential of the power semiconductor switch (21),
the auxiliary switch is a N-channel FET,
the saturation voltage signal line is connected to a drain terminal of the auxiliary switch through a resistor,
the output of the gate driver unit (22) is connected to a source terminal of the auxiliary switch, and
a second reference voltage line carrying the second reference voltage is connected to a gate terminal of the auxiliary switch through a resistor.

6. A monitoring device as claimed in claim 1 or 4, wherein
the second reference voltage is the emitter or source voltage potential of the power semiconductor switch,
the auxiliary switch is an NPN-type BJT,
the saturation voltage signal line is connected to a collector terminal of the auxiliary switch (21),
the output of the gate driver unit is connected to an emitter terminal of the auxiliary switch through a resistor,
a second reference voltage line carrying the second reference voltage is connected to a base terminal of the auxiliary switch through a resistor.

7. A monitoring device as claimed in any one of previous claims, wherein the measuring means comprise
at least one diode connected to a collector or drain terminal of the power semiconductor switch (21) for generating the saturation voltage signal, the diode blocking a flow of current from said collector or drain terminal to the saturation voltage signal.

8. A monitoring device as claimed in claim 3, wherein the feedback means (24) comprise
an isolator configured to produce the saturation feedback signal on the basis of the difference between the saturation voltage signal and the first reference voltage signal.

9. A monitoring device as claimed in claim 8, wherein the isolator is an optocoupler in which a resistance between two output terminals is responsive to a voltage difference between two input terminals, wherein the inputs are galvanically isolated from the outputs, and wherein one of the input terminals is connected to the saturation voltage signal through a resistor, the other input terminal is connected to the first reference voltage signal, and the saturation feedback signal is read between the two output terminals of the isolator.

10. A monitoring device as claimed in claim 4, wherein
the first reference voltage signal is a positive supply voltage supplying the gate driver unit (22).

11. An arrangement comprising
a power semiconductor switch (21) configured to be controlled on the basis of a gate voltage signal, and a monitoring device as claimed in any one of previous claims.

12. A method for monitoring a semiconductor switch (21) that is controlled to a conductive state or a non-conductive state on the basis of a gate voltage signal driven by a gate driver unit (22), wherein the method comprises
generating a saturation voltage signal on the basis of a voltage over the power semiconductor switch (21),
controlling the saturation voltage signal by using an auxiliary switch connected between a saturation voltage signal line carrying the saturation voltage signal and an output of the gate driver unit driving the gate voltage signal, the auxiliary switch being controlled to a conductive state or a non-conductive state on the basis of a difference between a second reference signal and the gate voltage signal so that, during the non-conductive state of the power semiconductor switch, the saturation voltage signal becomes responsive to the level of the gate voltage signal in order to use the saturation voltage signal for diagnosing a supply voltage of the gate driver, and

determining a saturation feedback signal on the basis of the saturation voltage signal,

wherein the second reference signal is a second reference voltage that is the emitter or source voltage potential of the power semiconductor switch (21),

or wherein the second reference signal is modulated in order to modulate the feedback signal during the non-conductive state of the power semiconductor switch (21) so that the frequency and/or duty cycle of the modulation of the feedback signal is responsive to a level of a positive supply voltage and/or a negative supply voltage supplying the gate driver unit (22).

**Patentansprüche**

1. Überwachungsvorrichtung für einen Leistungshalbleiterschalter (21), der in einen leitenden Zustand oder einen nichtleitenden Zustand auf der Grundlage eines Gatespannungssignals, das von einer Gatetreibereinheit (22) zugeführt wird, steuerbar ist, wobei die Vorrichtung aufweist

eine Messeinrichtung (23) zur Erzeugung eines Sättigungsspannungssignals auf der Grundlage einer Spannung an dem Leistungshalbleiterschalter (21),

einen Hilfsschalter, der zwischen einer Sättigungsspannungssignalleitung, die das Sättigungsspannungssignal führt, und einem Ausgang der Gatetreibereinheit (22), die das Gatespannungssignal erzeugt, angeschlossen ist, wobei der Hilfsschalter ausgebildet ist, auf der Grundlage einer Differenz zwischen einem zweiten Referenzsignal und dem Gatespannungssignal in einen leitenden Zustand oder einen nichtleitenden Zustand gesteuert zu werden, so dass das Sättigungsspannungssignal auf den Pegel des Gatespannungssignals während des nichtleitenden Zustands des Leistungshalbleiterschalters (21) anspricht, und das Sättigungsspannungssignal zur Bewertung einer Versorgungsspannung der Gatetreibereinheit (22) verwendbar ist, und

eine Rückkopplungseinrichtung (24) zur Erzeugung eines Sättigungsrückkopplungssignals auf der Grundlage des Sättigungsspannungssignals,

wobei

das zweite Referenzsignal eine zweite Referenzspannung ist, die das Emitter- oder Source-Spannungspotential des Leistungshalbleiterschalters (21) ist,

oder wobei die Vorrichtung eine Referenzspannungserzeugungseinrichtung (76) zur Erzeugung des zweiten Referenzsignals aufweist, wobei die Referenzspannungserzeugungseinrichtung (76) ausgebildet ist, das zweite Referenzsignal zu modulieren, um das Rückkopplungssignal während des nichtleitenden Zustands des Leistungshalbleiterschalters (21) zu modulieren, wobei die Frequenz und/oder das Tastverhältnis der Modulation des Rückkopplungssignals auf einen Pegel einer positiven Versorgungsspannung und/oder einer negativen Versorgungsspannung, die die Gatetreibereinheit (22) speisen, ansprechen.

2. Überwachungsvorrichtung nach Anspruch 1, wobei die Vorrichtung ausgebildet ist, das Sättigungsspannungssignal auf der Grundlage des Betriebszustands des Leistungshalbleiterschalters (21) zu steuern.

3. Überwachungsvorrichtung nach Anspruch 1 oder 2, wobei das Sättigungsrückkopplungssignal auf der Grundlage einer Differenz zwischen einer ersten Referenzspannung und dem Sättigungsspannungssignal bestimmt wird.

4. Überwachungsvorrichtung nach Anspruch 1, wobei

die zweite Referenzspannung das Emitter- oder Source-Spannungspotenzial des Leistungshalbleiterschalters (21) ist,

die zweite Referenzspannung aus einem Neben-Emitter des Leistungshalbleiterschalters (21) gemessen wird.

5. Überwachungsvorrichtung nach Anspruch 1 oder 4, wobei

die zweite Referenzspannung das Emitter- oder Source-Spannungspotenzial des Leistungshalbleiterschalters (21) ist,

der Hilfsschalter ein N-Kanal-FET ist,

die Sättigungsspannungssignalleitung mit einem Drainanschluss des Hilfsschalters über einen Widerstand verbunden ist,

der Ausgang der Gatetreibereinheit (22) mit einem Sourceanschluss des Hilfsschalters verbunden ist,

eine zweite Referenzspannungsleitung, die die Referenzspannung führt, mit einem Gateanschluss des Hilfsschalters über einen Widerstand verbunden ist.

6. Überwachungsvorrichtung nach Anspruch 1 oder 4, wobei
die zweite Referenzspannung das Emitter- oder Source-Spannungspotenzial des Leistungshalbleiterschalters ist,
der Hilfsschalter ein BJT des NPN-Typs ist,
die Sättigungsspannungssignalleitung mit einem Kollektoranschluss des Hilfsschalters (21) verbunden ist,
der Ausgang der Gatetreibereinheit mit einem Emitteranschluss des Hilfsschalters über einen Widerstand verbunden ist,
eine zweite Referenzspannungsleitung, die die zweite Referenzspannung führt, über einen Widerstand mit einem Basisanschluss des Hilfsschalters verbunden ist.

7. Überwachungsvorrichtung nach einem der vorhergehenden Ansprüche, wobei die Messeinrichtung aufweist mindestens eine Diode, die mit einem Kollektor- oder Drainanschluss des Leistungshalbleiterschalters (21) zur Erzeugung des Sättigungsspannungssignals verbunden ist, wobei die Diode einen Stromfluss des Kollektor- oder Drainanschlusses zu dem Sättigungsspannungssignal sperrt.

8. Überwachungsvorrichtung nach Anspruch 3, wobei die Rückkopplungseinrichtung (24) aufweist einen Isolator, der ausgebildet ist, das Sättigungsrückkopplungssignal auf der Grundlage der Differenz zwischen dem Sättigungsspannungssignal und dem ersten Referenzspannungssignal zu erzeugen.

9. Überwachungsvorrichtung nach Anspruch 8, wobei der Isolator ein Optokoppler ist, in welchem ein Widerstand zwischen zwei Ausgangsanschlüssen auf eine Spannungsdifferenz zwischen zwei Eingangsanschlüssen anspricht, wobei die Eingänge galvanisch von den Ausgängen getrennt sind, und wobei einer der Eingangsanschlüsse mit dem Sättigungsspannungssignal über einen Widerstand verbunden ist, der andere Eingangsanschluss mit dem ersten Referenzspannungssignal verbunden ist und das Sättigungsrückkopplungssignal zwischen den zwei Ausgangsanschlüssen des Isolators ausgelesen wird.

10. Überwachungsvorrichtung nach Anspruch 4, wobei
das erste Referenzspannungssignal eine positive Versorgungsspannung ist, die die Gatetreibereinheit (22) speist.

11. Anordnung, mit
einem Leistungshalbleiterschalter (21), der auf der Grundlage eines Gatespannungssignals steuerbar ist, und einer Überwachungsvorrichtung nach einem der vorhergehenden Ansprüche.

12. Verfahren zur Überwachung eines Halbleiterschalters (21), der auf der Grundlage eines Gatespannungssignals, das von einer Gatetreibereinheit (22) erzeugt wird, in einen leitenden Zustand oder einen nichtleitenden Zustand steuerbar ist, wobei das Verfahren umfasst
Erzeugen eines Sättigungsspannungssignals auf der Grundlage einer Spannung an dem Leistungshalbleiterschalter (21),
Steuern des Sättigungsspannungssignals durch Verwenden eines Hilfsschalters, der zwischen einer Sättigungsspannungssignalleitung, die das Sättigungsspannungssignal führt, und einem Ausgang der Gatetreibereinheit, die das Gatespannungssignal bereitstellt, angeschlossen ist, wobei der Hilfsschalter auf der Grundlage einer Differenz zwischen einem zweiten Referenzsignal und dem Gatespannungssignal in einen leitenden Zustand oder einen nichtleitenden Zustand steuerbar ist derart, dass während des nichtleitenden Zustands des Leistungshalbleiterschalters das Sättigungsspannungssignal auf den Pegel des Gatespannungssignals derart anspricht, dass das Sättigungsspannungssignal zur Bewertung einer Versorgungsspannung der Gatetreibereinheit verwendbar ist, und
Bestimmen eines Sättigungsrückkopplungssignals auf der Grundlage des Sättigungsspannungssignals,
wobei das zweite Referenzsignal eine zweite Referenzspannung ist, die das Emitter- oder Source-Spannungspotenzial des Leistungshalbleiterschalters (21) ist,
oder wobei das zweite Referenzsignal moduliert wird, um das Rückkopplungssignal während des nichtleitenden Zustands des Leistungshalbleiterschalters (21) so zu modulieren, dass die Frequenz und/oder das Tastverhältnis der Modulation des Rückkopplungssignals auf einen Pegel einer positiven Versorgungsspannung und/oder einer negativen Versorgungsspannung, die die Gatetreibereinheit (22) speisen, ansprechen.

**Revendications**

1. Dispositif de surveillance pour un commutateur de puissance à semiconducteur (21) configuré pour être contrôlé selon un état conducteur ou un état non conducteur en fonction d'un signal de tension de porte piloté par une unité de pilote de porte (22), dans lequel le dispositif comprend

un moyen de mesure (23) pour une génération d'un signal de tension de saturation en fonction d'une tension sur le commutateur de puissance à semiconducteur (21),

un commutateur auxiliaire connecté entre une ligne de signal de tension de saturation véhiculant le signal de tension de saturation et une sortie de l'unité de pilote de porte (22) pilotant le signal de tension de porte, dans lequel le commutateur auxiliaire est configuré pour être contrôlé selon un état conducteur ou un état non conducteur en fonction d'une différence entre un deuxième signal de référence et le signal de tension de porte de sorte que le signal de tension de saturation devienne réactif au niveau du signal de tension de porte durant l'état non conducteur du commutateur de puissance à semiconducteur (21) afin d'utiliser le signal de tension de saturation pour un diagnostic d'une tension d'alimentation du pilote de porte (22), et

un moyen de retour (24) pour une génération d'un signal de retour de saturation en fonction du signal de tension de saturation,

dans lequel

le deuxième signal de référence est une deuxième tension de référence qui est l'émetteur ou le potentiel de tension source du commutateur de puissance à semiconducteur (21),

ou dans lequel le dispositif comprend un moyen de génération de tension de référence (76) pour une génération du deuxième signal de référence, dans lequel le moyen de génération de tension de référence (76) est configuré pour moduler le deuxième signal de référence afin de moduler le signal de retour durant l'état non conducteur du commutateur de puissance à semiconducteur (21), dans lequel, la fréquence et/ou le cycle de service de la modulation du signal de retour est réactif à un niveau d'une tension d'alimentation positive et/ou une tension d'alimentation négative alimentant l'unité de pilote de porte (22).

2. Le dispositif de surveillance tel que revendiqué à la revendication 1, dans lequel le dispositif est configuré pour contrôler le signal de tension de saturation en fonction de l'état opérationnel du commutateur de puissance à semiconducteur (21).

3. Le dispositif de surveillance tel que revendiqué à la revendication 1 ou 2, dans lequel le signal de retour de saturation est déterminé en fonction d'une différence entre une première tension de référence et le signal de tension de saturation.

4. Le dispositif de surveillance tel que revendiqué à la revendication 1, dans lequel la deuxième tension de référence est l'émetteur ou le potentiel de tension source du commutateur de puissance à semiconducteur (21), la deuxième tension de référence est mesurée à partir d'un émetteur auxiliaire du commutateur de puissance à semiconducteur (21).

5. Le dispositif de surveillance tel que revendiqué à la revendication 1 ou 4, dans lequel
la deuxième tension de référence est l'émetteur ou le potentiel de tension source du commutateur de puissance à semiconducteur (21),
le commutateur auxiliaire est un FET à canal N,
la ligne de signal de tension de saturation est connectée à une borne de drain du commutateur auxiliaire via une résistance,
la sortie de l'unité de pilote de porte (22) est connectée à une borne de source du commutateur auxiliaire, et
une deuxième ligne de tension de référence véhiculant la deuxième tension de référence est connectée à une borne de porte du commutateur auxiliaire via une résistance.

6. Le dispositif de surveillance tel que revendiqué à la revendication 1 ou 4, dans lequel
la deuxième tension de référence est l'émetteur ou le potentiel de tension source du commutateur de puissance à semiconducteur,
le commutateur auxiliaire est un BJT de type NPN,
la ligne de signal de tension de saturation est connectée à une borne de collecteur du commutateur auxiliaire (21),
la sortie de l'unité de pilote de porte est connectée à une borne d'émetteur du commutateur auxiliaire via une résistance,
une deuxième ligne de tension de référence véhiculant la deuxième tension de référence est connectée à une borne de base du commutateur auxiliaire via une résistance.

7. Le dispositif de surveillance tel que revendiqué à l'une quelconque des précédentes revendications, dans lequel le moyen de mesure comprend

au moins une diode connectée à une borne de collecteur ou de drain du commutateur de puissance à semiconducteur (21) pour une génération du signal de tension de saturation, la diode bloquant un flux de courant provenant de ladite borne de collecteur ou de drain vers le signal de tension de saturation.

8. Le dispositif de surveillance tel que revendiqué à la revendication 3, dans lequel le moyen de retour (24) comprend un isolateur configuré pour produire le signal de retour de saturation en fonction de la différence entre le signal de tension de saturation et le premier signal de tension de référence.

9. Le dispositif de surveillance tel que revendiqué à la revendication 8, dans lequel l'isolateur est un optocoupleur dans lequel une résistance entre deux bornes de sortie est réactive à une différence de tension entre deux bornes d'entrée, dans lequel les entrées sont galvaniquement isolées des sorties, et dans lequel une des bornes d'entrée est connectée au signal de tension de saturation via une résistance, l'autre borne d'entrée est connectée au premier signal de tension de référence, et le signal de retour de saturation est lu entre les deux bornes de sortie de l'isolateur.

10. Le dispositif de surveillance tel que revendiqué à la revendication 4, dans lequel le premier signal de tension de référence est une tension d'alimentation positive alimentant l'unité de pilote de porte (22) .

11. Une disposition comprenant un commutateur de puissance à semiconducteur (21) configuré pour être contrôlé en fonction d'un signal de tension de porte, et un dispositif de surveillance tel que revendiqué à l'une quelconque des revendications précédentes.

12. Procédé de surveillance d'un commutateur à semiconducteur (21) qui est contrôlé selon un état conducteur ou un état non conducteur en fonction du signal de tension de porte piloté par une unité de pilote de porte (22), dans lequel le procédé comprend une génération d'un signal de tension de saturation en fonction d'une tension sur le commutateur de puissance à semiconducteur (21), contrôle du signal de tension de saturation en utilisant un commutateur auxiliaire connecté entre une ligne de signal de tension de saturation véhiculant le signal de tension de saturation et une sortie de l'unité de pilote de porte pilotant le signal de tension de porte, le commutateur auxiliaire étant contrôlé selon un état conducteur ou un état non conducteur en fonction d'une différence entre un deuxième signal de référence et le signal de tension de porte de sorte que, durant l'état non conducteur du commutateur de puissance à semiconducteur, le signal de tension de saturation devienne réactif au niveau du signal de tension de porte afin d'utiliser le signal de tension de saturation pour un diagnostic d'une tension d'alimentation du pilote de porte, et détermination d'un signal de retour de saturation en fonction du signal de tension de saturation, dans lequel le deuxième signal de référence est une deuxième tension de référence qui est l'émetteur ou le potentiel de tension source du commutateur de puissance à semiconducteur (21), ou dans lequel le deuxième signal de référence est modulé afin de moduler le signal de retour durant l'état non conducteur du commutateur de puissance à semiconducteur (21) de sorte que la fréquence et/ou le cycle de service de la modulation du signal de retour est réactif à un niveau d'une tension d'alimentation positive et/ou une tension d'alimentation négative alimentant l'unité de pilote de porte (22) .

Figure 1a

Figure 1b

Figure 2

Figure 3a

Figure 3b

Figure 3c

Figure 3d

Figure 4

Figure 5

Figure 6

Figure 7

Figure 8a

Figure 8b

Figure 8c

Figure 8d

Figure 8e

Figure 8f

**EP 2 887 546 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2007070567 A1

- US 7768337 B